# EUROPEAN PATENT APPLICATION

(11) **EP 3 462 475 A2**
(43) Date of publication of application: **03.04.2019**
(21) Application number: 18195508.9
(22) Date of filing: 19.09.2018
(51) Int. Cl.: H01J 37/20, H01J 37/22

(54) **LUMINESCENCE COLLECTING DEVICE**

(30) Priority: 29.09.2017 JP 2017191654; 12.07.2018 JP 2018132685
(71) Applicant: Horiba, Ltd., Kyoto-shi, Kyoto 601-8510 (JP)
(72) Inventor: HIGUCHI, Seiji, Kyoto, 601-8510 (JP); AKIYAMA, Hisashi, Kyoto, 601-8510 (JP); OHMORI, Haruo, Tokyo, 143-0024 (JP)
(74) Representative: Isarpatent

(57) **Abstract**

The present invention is a luminescence collecting device 100 capable of efficiently collecting cathodoluminescence and also dramatically decreasing thickness as compared with conventional devices. In addition, the luminescence collecting device 100 is adapted to include: a holder forming member 1 formed with a sample holder 11 on which a sample is placed; a reflective mirror forming member 2 formed with a reflective mirror 21 for reflecting cathodoluminescence emitted from the sample and guiding the reflected cathodoluminescence to a predetermined light collecting surface S; and a positioning mechanism 3 adapted to set the relative position of the reflective mirror 21 to the sample holder 11 to a sole predetermined position by bringing a contact surface provided on the holder forming member 1 and a contact surface provided on the reflective mirror forming member 2 into abutting contact.

## Description

### Technical Field

The present invention relates to a light collecting device adapted to collect cathodoluminescence emitted when irradiating a sample with an electron beam, and the like, and in particular, to a light collecting device preferably used for electron microscopes.

### Background Art

This sort of luminescence collecting device is one used, for example, inserted between the polepieces of a transmission electron microscope (TEM), and has a reflective mirror for reflecting cathodoluminescence emitted from a sample and guide the reflected cathodoluminescence to a detector having a spectrometer directly or through a light guide such as an optical fiber.

Meanwhile, as described in Patent Literature 1, the distance between the polepieces is desirably short in terms of improving device performance such as resolution, and therefore the thickness of the luminescence collecting device to be inserted between the polepieces is also desirably made as small as possible.

However, for example, if a thickness dimension is limited by providing the reflective mirror only above or below the sample or by another means, the efficiency of collecting cathodoluminescence whose intensity is intrinsically weak is reduced, causing some problems such as deterioration in SN ratio.

In addition, the conventional luminescence collecting device has a slide adjustment mechanism and the like for adjusting the position of the reflective mirror, and therefore there is also a problem that the mechanism makes it difficult to decrease the thickness dimension by a certain amount or more.

### Citation List

### Patent Literatures

Patent Literature 1: Japanese Unexamined Patent Application Publication No. 2015-503198

### Summary of Invention

### Technical Problem

The present invention has been made in consideration of the above-described problems, and a main intended object thereof is to provide a luminescence collecting device capable of efficiently collecting cathodoluminescence and also dramatically decreasing thickness as compared with conventional devices.

### Solution to Problem

That is, the luminescence collecting device according to the present invention is one adapted to collect cathodoluminescence emitted by irradiating a sample with an electron beam, and the luminescence collecting device includes: a holder forming member formed with a sample holder on which the sample is placed; a reflective mirror forming member formed with a reflective mirror for reflecting the cathodoluminescence emitted from the sample and guiding the reflected cathodoluminescence to a predetermined light collecting surface; and a positioning mechanism adapted to set the relative position of the reflective mirror to the sample holder to a sole predetermined position by bringing a contact surface provided on the holder forming member and a contact surface provided on the reflective mirror forming member into abutting contact.

In such a configuration, positioning is performed only by the mechanical abutting contact, and therefore the need for a position adjustment mechanism for the reflective mirror, or the like is eliminated, thus simplifying structure and enabling a decrease in thickness. As a result, the luminescence collecting device becomes adaptable to, for example, electron microscopes having a small inter-polepiece dimension.

More specific embodiments can include one configured such that the sample holder is provided protruding on the front end part of the holder forming member, a protruding direction of the sample holder is set to be orthogonal to an electron beam irradiation direction, and the reflective mirror forming member is attached fitted to the front end side of the holder forming member. In addition to this, the positioning mechanism includes: first contact surfaces that are opposite surfaces respectively provided on the sample holder forming member and the reflective mirror forming member orthogonally to the protruding direction; one or more convex parts that are provided on any one of the sample holder forming member and the reflective mirror forming member in such a manner as to extend in the protruding direction; and one or more concave part that are provided on the other one of the sample holder forming member and the reflective mirror forming member in such a manner as to be recessed in the protruding direction, and is configured so that positioning in the protruding direction is performed by abutting contact between the first contact surfaces, and positioning in a direction orthogonal to the protruding direction is performed by abutting contact between second contact surfaces that are side circumferential surfaces of each of the convex parts and a corresponding one of the concave parts.

In order to make thickness as small as possible, it is preferable that given that a direction orthogonal to the protruding direction and to the electron beam irradiation direction is defined as a left-right direction, the convex parts and the concave parts are provided on any or both of left and right of the reflective mirror. In such a configuration, the light colleting device can be thinned with the dimension of the light colleting device in a thickness direction decreased to the extent of being almost the same as the dimension of the reflective mirror in the thickness direction.

In addition, as a result, even when the reflective mirror is configured to cover the sample from above and below (from both sides in the thickness direction), and the dimension of the reflective mirror in the thickness direction is increased to focus on light collecting efficiency, the light collecting device can keep thickness thin enough to be insertable between the polepieces of an existing electron microscope.

As long as the luminescence collecting device further includes one or more fixing mechanisms adapted to fix the reflective mirror forming member to the predetermined position with respect to the holder forming member, and the fixing mechanisms are provided on any or both of left and right of the reflective mirror, such a configuration can contribute to a decrease in thickness.

### Advantageous Effects of Invention

As described above, according to the present invention, positioning is performed only by the mechanical abutting contact, and therefore the need for a position adjustment mechanism for the reflective mirror, or the like is eliminated, thus simplifying structure and enabling a decrease in thickness. As a result, the luminescence collecting device becomes adaptable to, for example, electron microscopes having a small inter-polepiece dimension.

### Brief Description of Drawings

FIG. 1 is a vertical cross-sectional view illustrating a state where a luminescence collecting device according to one embodiment of the present invention is arranged between polepieces and cut along a thickness direction;
FIG. 2 is an exploded perspective view of the luminescence collecting device in the same embodiment;
FIG. 3 is a vertical cross-sectional view when cutting the luminescence collecting device in the same embodiment in a left-right direction;
FIG. 4 is an exploded cross-sectional view when cutting the luminescence collecting device in the same embodiment in the left-right direction;
FIG. 5 is a schematic diagram illustrating a cooling mechanism in another embodiment of the present invention; and
FIG. 6 is a vertical cross-sectional view when cutting a luminescence collecting device in still another embodiment of the present invention in a thickness direction.

### Description of Embodiments

In the following, a light collecting device 100 (a luminescence collecting device in the claims) according to one embodiment of the present invention will be described with reference to drawings.

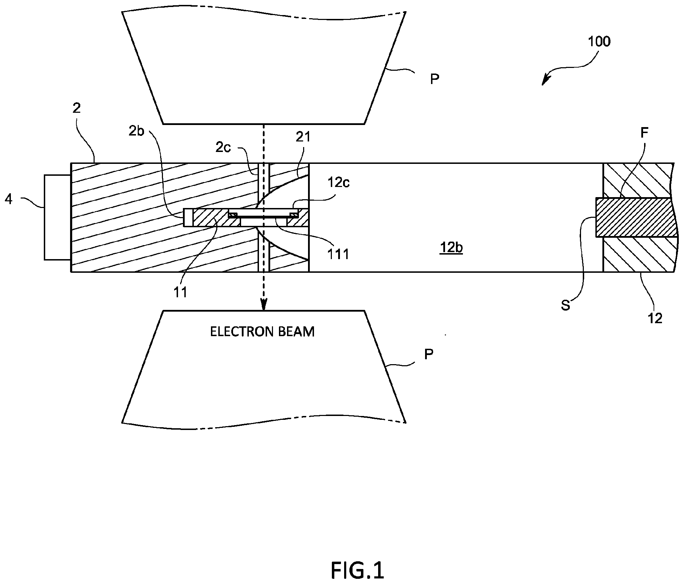

As illustrated in FIG. 1, the light collecting device 100 according to the present embodiment is one adapted to be inserted between the polepieces P of an electron microscope while holding a sample, as well as to fulfill a function of collecting cathodoluminescence emitted from the sample irradiated with an electron beam and guiding the collected cathodoluminescence to an unillustrated light receiving element.

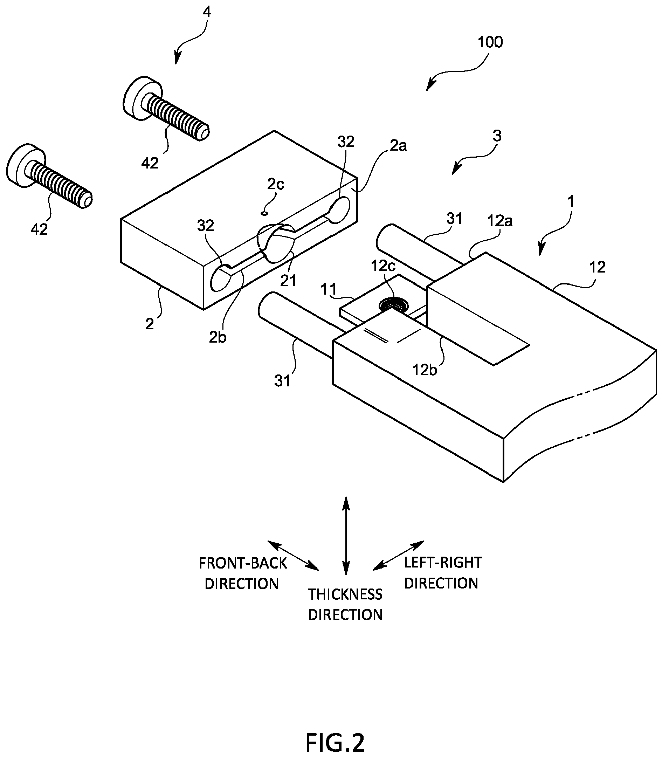

Describing more specifically, as illustrated in drawings such as FIGS. 2 to 4, the light collecting device 100 includes: a holder forming member 1 formed with a sample holder 11 on which the sample is placed; a reflective mirror forming member 2 formed with a reflective mirror 21 for reflecting the cathodoluminescence emitted from the sample and guiding the reflected cathodoluminescence to a predetermined light collecting surface S; a positioning mechanism 3 adapted to position the reflective mirror forming member 2 in the predetermined position of the holder forming member 1; and a fixing mechanism 4 adapted to fix the positioned reflective mirror forming member 2 to the holder forming member 1.

The respective parts will be described.

The holder forming member 1 is one including a base body 12 of a flat rectangular plate shape and the sample holder 11 of a rectangular plate shape integrally protruding from the front end surface of the base body 12. In addition, in the following, the protruding direction of the sample holder 111 is also referred to as a front-back direction, the planar direction of the base body 12 (and the sample holder 11) to a thickness direction, and a direction orthogonal to the front-back direction and to the thickness direction to a left-right direction.

The base body 12 is formed with a cutout 12b having a constant width and extending backward from the center of the front end surface 12a of the base body 12 in a plan view, and also configured such that the front end surface of an optical fiber F inserted from the back side of the base body 12 is exposed on the bottom surface of the cutout. The front end surface of the optical fiber F serves as the light collecting surface S. In addition, the light collecting surface S protrudes from the bottom surface, but may be set in a recessed position.

The sample holder 11 is one of a rectangular plate shape whose thickness is further thinner than the base body 12 and whose dimension in the left-right direction is also smaller than a light collecting body. In addition, the sample holder 11 is extended integrally from the front end surface of the base body 12 with the centerlines in the thickness direction and in the left-right direction made coincident. Further, in the center of the sample holder 11 closer to the front end, a through-hole 12c penetrating in the thickness direction is provided, and over the center of the through-hole 12c in the thickness direction, a mesh-like sheet 111 is stuck as illustrated in FIG. 1. The sample is placed and held on the central part of the sheet 111. That is, the central part of the sheet sticking area serves as a sample holding area of the sample holder 11.

The reflective mirror forming member 2 is one of a flat rectangular plate shape whose thickness is the same as or slightly larger than the base body 12 of the holder forming member 1, and in the center of the back end surface 2a thereof, a concave part of a partial elliptical spherical shape whose surface serves as the reflective mirror 21 is provided. The opening diameter of the concave part, i.e., the opening diameter of the reflective mirror is set to be the same as or approximately slightly smaller (80 % to 95 % by ratio) than the dimension of the back end surface 2a of the reflective mirror forming member 2 in the thickness direction.

Also, the back end surface 2a is formed with a holder insertion groove 2b extending in the left-right direction along the center in the thickness direction. The thickness of the holder insertion groove 2b is set to be the same as the thickness of the sample holder 11, and configured so that the sample holder 11 is fitted into the holder insertion groove 2b without backlash in the thickness direction. In addition, the holder forming member 1 and the reflective mirror forming member 2 are configured so that when attaching the reflective mirror forming member 2 to a predetermined position of the front end part of the holder forming member 1, the front end part of the sample holder 11 is inserted into the holder insertion groove 2b, and the reflective mirror 21 covers the sample holding area of the sample holder 11 from the front end side. Further, above and below of the focus position of the reflective mirror 21, i.e., in the thickness direction, a beak through-hole 2c for allowing the electron beam to pass through is provided.

The positioning mechanism 3 is one that brings contact surfaces respectively provided on the holder forming member 1 and the reflective mirror forming member 2 into abutting contact with each other, and thereby makes the relative position of the reflective mirror 21 to the sample holder 11 coincident with the predetermined position, i.e., makes one elliptical focal point of the reflective mirror 21 coincident with the center of the sample holding area as a sole position. In addition, the other elliptical focal point of the reflective mirror 21 is positioned on the light collecting surface S.

Describing the positioning mechanism 3 in detail, this one performs positioning in the front-back direction using the abutting contact between the front end surface 12a of the base body 12 of the holder forming member 1 and the back end surface 2a of the reflective mirror forming member 2, and also performs positioning in the left-right direction and in the thickness direction using the backlash-free fitting of a concave-convex structure provided between the holder forming member 1 and the reflective mirror forming member 2 (using the abutting contact between the side circumferential surfaces of concave and convex structures).

In this embodiment, the concavo-convex structure is one configured to include: a pair of isodiametric columnar-shaped pin members 31 protruding in the protruding direction from both sides of the sample holder 11 in the left-right direction on the front end surface 12a of the base body 12; and a pair of fitting holes 32 provided penetrating in the front-back direction at positions corresponding to the pin members 31 in the back end surface 2a of the reflective mirror forming member 2.

To perform the positioning, the back end surface 2a of the reflective mirror forming member 2 is brought close to the front end side of the holder forming member 1 to fit the respective pin members 31 into corresponding ones of the fitting holes 32, as well as to bring the back end surface 2a of the reflective mirror forming member 2 into abutting contact with the front end surface 12a of the base body 12 of the holder forming member 1.

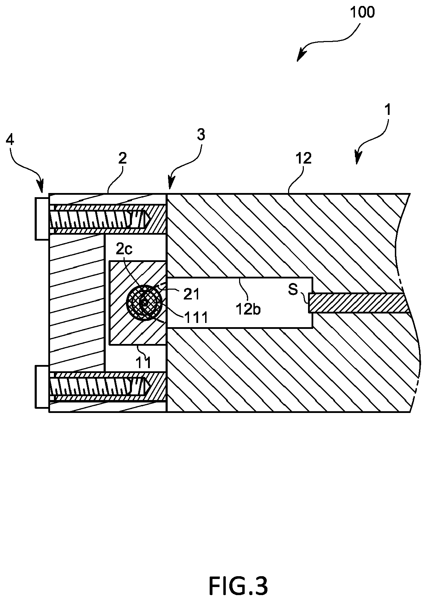

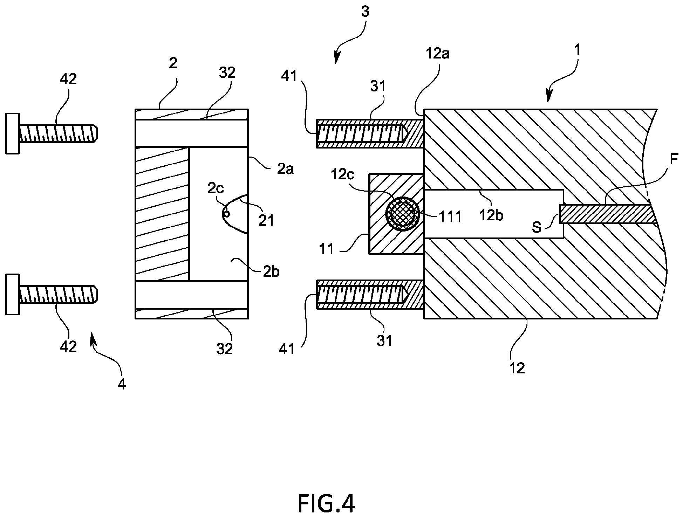

As illustrated in FIGS. 3 and 4, the fixing mechanism 4 is one configured to include: female screw holes 41 opened in the front ends of the pin members 31: and screws 42 screwable into the female screw holes 41. In addition, by inserting the screws 42 from the front end openings of the fitting holes 32 to screw up the screws 42 into the female screw holes 41 of the pin members 31 present inside the fitting holes 32, the heads of the screws 42 press the front end surface 12a of the reflective mirror forming member 2 to fix the reflective mirror forming member 2 in the predetermined position so that the reflective mirror forming member 2 can be prevented from coming off from the holder forming member 1. In addition, the outside diameters of the heads of the screws 42 are set to be smaller than the thickness dimension of the reflective forming member 2, and in a state where the screws 42 are attached, the heads are positioned within the thickness of the reflective mirror forming member 2.

The light collecting device 100 configured by fitting the reflective mirror forming member 2 to the front end part of the holder forming member 1 as described above is inserted between the polepieces P with the thickness direction thereof made coincident with an irradiation direction of the electron beam, and arranged in a position where the electron beam passes through the beam through-hole 2c.

Then, when the electron beam is emitted, the sample inside is irradiated with the electron beam through the beam through-hole 2c, and from an irradiation site of the sample, the cathodoluminescence is generated. The cathodoluminescence is reflected by the reflective mirror 21, condensed on the light collecting surface S in the other focus position, introduced into the optical fiber, and guided to the unillustrated light receiving element.

That is, the light collecting device 100 configured as described above employs the positioning mechanism 3 adapted to position the reflective mirror 21 in the sole predetermined position only using the mechanical contact surfaces, and eliminates the need for an adjustment mechanism or the like, and is therefore simple in configuration. In addition, since the positioning mechanism 3 and the fixing mechanism 4 are provided substantially only in the left-right direction of the reflective mirror 21 and arranged within the thickness of the reflective mirror 21, the dimension of the light collecting device 100 in the thickness direction is almost the same as the dimension of the reflective mirror 21 in the thickness direction.

Accordingly, even though the reflective mirror 21 is adapted to cover the upper and lower parts of the sample to improve light collecting efficiency, the thickness dimension of the light collecting device 100 can be kept extremely small, and therefore the light collecting device 100 is sufficiently adaptable even to electron microscopes having a small inter-polepiece dimension.

Note that the present invention is not limited to the above-described embodiment. For example, the concavo-convex structure may be a structure in which the reflective mirror forming member is provided with pin members and the holder forming member is provided with fitting holes. Further, the concave-convex structure is not limited to the combination of the pin members and the fitting holes.

In addition, the light collecting device is not only for collecting cathodoluminescence in electron microscopes, but may also be used for collecting cathodoluminescence used in other analysis equipment and the like. Further, the light collecting device is also applicable to collecting photoluminescence.

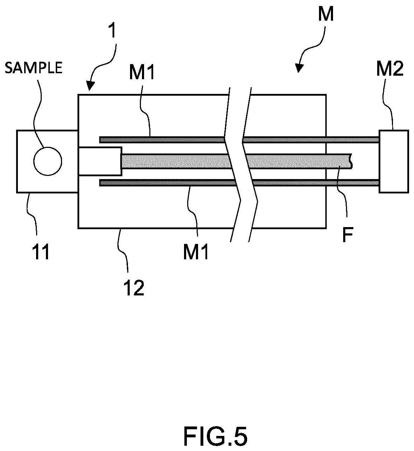

As illustrated in FIG. 5, a cooling mechanism M for cooling the sample holder 11 may be provided. When analyzing a sample, thermal noise may be problematic in terms of measurement accuracy. However, such a cooling mechanism M can suppress the effect of thermal noise.

The cooling mechanism M is one including, for example, thermal conductors M1 that penetrate from the front end part of the holder forming member 1 through the outer wall of a vacuum chamber (not illustrated) and reach the outside, and a cooling member M2 that is provided outside the vacuum chamber and connected to the thermal conductors M1.

As the thermal conductors M1, for example, heat pipe members are employed. The heat pipe members M1 are embedded in the base body 12 supporting the sample holder 11, and more specifically, the heat pipe members M1 are embedded as a pair along the optical fiber F on both sides of it. In addition, the cooing mechanism M is configured to remove the heat of the sample holder 11 through the heat pipe members M1 by connecting the cooling member M2 such as a heat exchanger to the outer ends of the heat pipe members M1. The thermal conductors M1 may be a member having high thermal conductivity such as Cu or Al.

Further, the base body 12 itself may be used as a thermal conductor. Alternatively, the sample holder 11 may be adapted to be cooled by providing a heat medium circulating path inside the base body 12 and forming a refrigeration cycle using a circulating heat medium, or by another means.

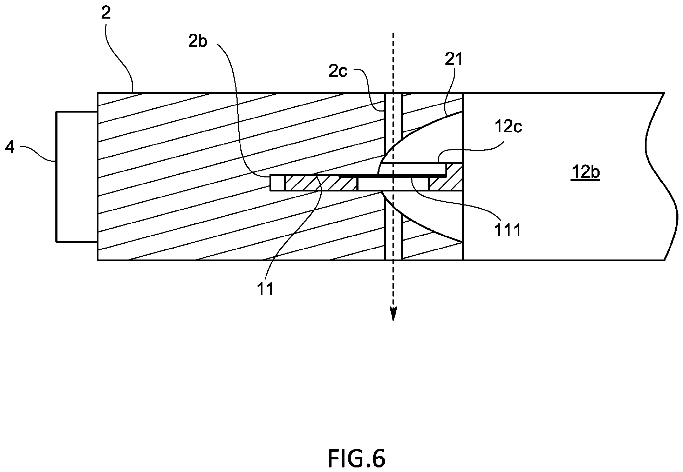

Still further, as illustrated in FIG. 6, the present invention may be configured such that, with the reflective mirror forming member 2 attached to the holder forming member 1, the sheet 111 stuck over the through-hole 12c of the sample holder 11 is sandwiched by the reflective mirror forming member 2 and the sample holder 11 and fixed on the sample holder 11. Such a configuration makes it possible to remarkably easily attach the sheet 111 to the sample holder 11. In addition, the sheet 111 is a mesh-like (grid-like) sheet, but may be a filmy transparent sheet as long as the sheet allows cathodoluminescence to transmit therethrough.

Besides, it goes without saying that the present invention can be variously modified without departing from the scope thereof.

### Reference Signs List

100: Luminescence collecting device
11: Sample holder
1: Holder forming member
S: Light collecting surface
21: Reflective mirror
2: Reflective mirror forming member
3: Positioning mechanism
2a: First contact surface (back end surface of reflective mirror forming member)
12a: First contact surface (front end surface)
31: Convex part (pin member)
32: Concave part (fitting hole)
4: Fixing mechanism
P: Polepiece

## Claims

1. A luminescence collecting device adapted to collect cathodoluminescence emitted by irradiating a sample with an electron beam, the luminescence collecting device comprising:
a holder forming member formed with a sample holder on which the sample is placed;
a reflective mirror forming member formed with a reflective mirror for reflecting the cathodoluminescence emitted from the sample and guiding the reflected cathodoluminescence to a predetermined light collecting surface; and
a positioning mechanism adapted to set a relative position of the reflective mirror to the sample holder to a sole predetermined position by bringing a contact surface provided on the holder forming member and a contact surface provided on the reflective mirror forming member into abutting contact.

2. The luminescence collecting device according to claim 1, configured such that the sample holder is provided protruding on a front end part of the holder forming member, a protruding direction of the sample holder is set to be orthogonal to an electron beam irradiation direction, and the reflective mirror forming member is attached fitted to a front end side of the holder forming member, wherein
the positioning mechanism comprises:
first contact surfaces that are opposite surfaces respectively provided on the sample holder forming member and the reflective mirror forming member orthogonally to the protruding direction;
one or more convex parts that are provided on any one of the sample holder forming member and the reflective mirror forming member in such a manner as to extend in the protruding direction; and
one or more concave part that are provided on the other one of the sample holder forming member and the reflective mirror forming member in such a manner as to be recessed in the protruding direction, and is configured so that
positioning in the protruding direction is performed by abutting contact between the first contact surfaces, and positioning in a direction orthogonal to the protruding direction is performed by abutting contact between second contact surfaces that are side circumferential surfaces of each of the convex parts and a corresponding one of the concave parts.

3. The luminescence collecting device according to claim 2, wherein
given that a direction orthogonal to the protruding direction and to the electron beam irradiation direction is defined as a left-right direction, the convex parts and the concave parts are provided on any or both of left and right of the reflective mirror.

4. The luminescence collecting device according to any of claims 1 to 3, further comprising
one or more fixing mechanisms adapted to fix the reflective mirror forming member to the predetermined position with respect to the holder forming member, wherein
the fixing mechanisms are provided on any or both of left and right of the reflective mirror.

5. The luminescence collecting device according to any of claims 1 to 4, further comprising
a cooling mechanism adapted to cool the sample holder, wherein
the cooling mechanism is one that transmits heat of the sample holder through a thermal conductor to an outer side of a vacuum chamber containing the sample holder.

6. The luminescence collecting device according to any of claims 1 to 5, configured such that a sheet having translucency is stuck over a through-hole provided in the sample holder, and the sample is placed on the sheet, wherein
the sheet is fixed to the sample holder by the reflective mirror forming member.

7. An electron microscope comprising
the luminescence collecting device according to any of claims 1 to 6 and a pair of polepieces between which an electron beam passes, wherein
the luminescence collecting device is inserted between the polepieces.

8. A positioning mechanism provided, in order to collect cathodoluminescence emitted by irradiating a sample with an electron beam, between a holder forming member formed with a sample holder on which the sample is placed and a reflective mirror forming member formed with a reflective mirror for reflecting the cathodoluminescence emitted from the sample and guiding the reflected cathodoluminescence to a predetermined light collecting surface,
the positioning mechanism being one adapted to comprise a contact surface provided on the holder forming member and a contact surface provided on the reflective mirror forming member and set a relative position of the reflective mirror to the sample holder to a sole predetermined position by bringing the contact surfaces into abutting contact with each other.
